# EUROPEAN PATENT APPLICATION

(11) **EP 1 244 142 A1**
(43) Date of publication of application: **25.09.2002**
(21) Application number: 01870060.9
(22) Date of filing: 23.03.2001
(51) Int. Cl.: H01L 21/336, H01L 21/762

(54) **Fabrication method of SOI semiconductor devices**

(71) Applicant: UNIVERSITE CATHOLIQUE DE LOUVAIN, 1348 Louvain la Neuve (BE)
(72) Inventor: Flandre, Denis, 1170 Bruxelles (BE); Neve de Mevergnies, Amaury, 1050 Ixelles (BE); Raskin, Jean-Pierre, 1348 Louvain-la-Neuve (BE)
(74) Representative: Bird, William Edward

(57) **Abstract**

The present invention relates to a method for fabrication of semiconductor devices, in particular but not limited to the fabrication of double gate transistors of the type Gate-All-Around or "semiconductor-on-nothing" transistors and devices.

A method according to the present invention comprises the steps of:
(a) forming a trench in at least a first substrate,
(b) transferring semiconductor material over the trench to form a semiconductor bridge across the trench, the semiconductor bridge defining an active area,
(c) forming a gate insulator on the semiconductor bridge, and
(d) applying gate material on the gate insulator, thus forming a gate.

## Description

### Technical field of the invention

The present invention relates to a method for fabrication of semiconductor devices, in particular but not limited to the fabrication of double gate transistors of the type Gate-All-Around (GAA) or "semiconductor on nothing" transistors and circuits.

### Background of the invention

The microelectronics industry is driven by a need for high performance circuits and devices. This performance is doubled about every 18 months. The mainstream devices available today are bulk silicon single-gate MOS transistors. With the aggressive reduction of dimensions, which is the present trend in the microelectronics industry, more and more limitations of classical single-gate MOS transistors appear. The most annoying effects are the so-called short-channel effects. They represent the loss of control of the front gate on the channel when compared to the parasitic control of source and drain.

Since many years, research groups have shown that the use of double-gate devices can drastically improve the performances of MOS transistors, and reduce the negative effects associated to the reduction of dimensions. Moreover, these devices present a transconductance that has a value which is more than twice the value of the transconductance in single-gate devices. Various fabrication methods are proposed in the literature, but none of them has lead to a widely-accepted process yet. These methods are often too complex or create non-desirable high parasitic capacitances values.

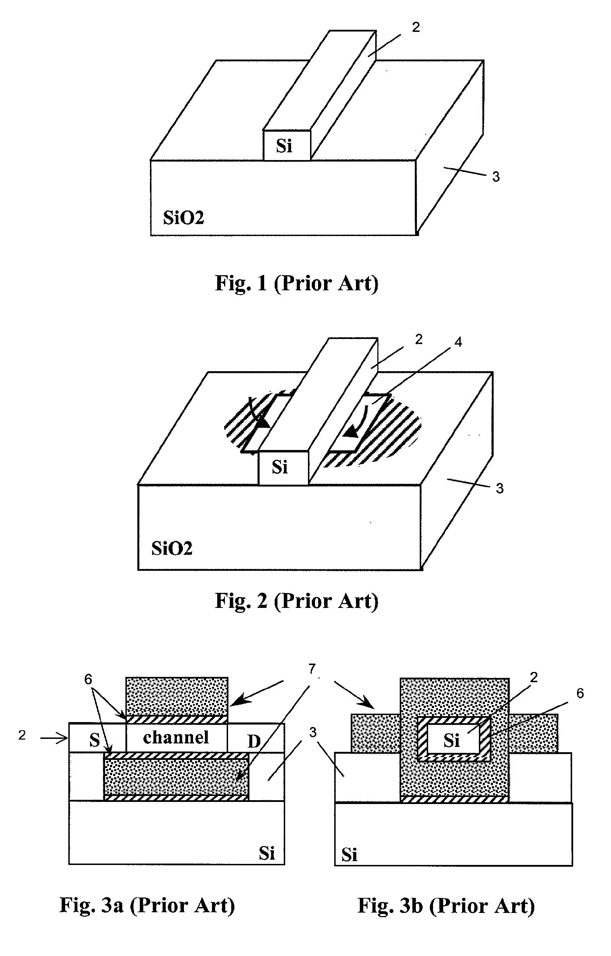

In 'Silicon-On-Insulator "Gate-All-Around Device'", Colinge et al., IEDM 90, pp.595-598, a fabrication method for GAA devices is proposed. In GAA devices the gate completely surrounds the channel, as shown in Fig. 3b, while in double-gate devices there is one front gate and one back gate (or one top gate and one bottom gate) which must be connected together. The described process starts with a SIMOX wafer (Separation by Implanted Oxygen, a form of Silicon-On-Insulator or SOI). A silicon island 2 is etched in the thin silicon film, as shown in Fig. 1. The wafer is then covered with photoresist, and windows are opened at the future intersections of the active area and the gate. A cavity 4 is isotropically etched in the oxide layer 3 underneath the silicon island 2. Thus at this step a free-standing silicon bridge is formed over a cavity 4 in the oxide 3. This is shown in Fig. 2. A gate oxide 6 is grown over the whole silicon bridge and implantations are made to adjust the threshold voltage. Gate polysilicon 7 is then deposited by LPCVD over the gate oxide 6. The whole cavity 4 is filled with polysilicon, which is also deposited at the sides and the upper part of the silicon island 2. A front polysilicon gate is then patterned. A longitudinal vertical cross-section of the device obtained is represented in Fig. 3a, and a transversal vertical cross-section of the device obtained is represented in Fig. 3b. The gate thus completely surrounds the channel, as shown in Fig. 3b. The remaining of the process is as usual in CMOS technology: source and drain implantations, oxidation, opening of the contact holes and metallization.

This process has been used for many years at the U.C.L. Microelectronics Laboratory. However, drawbacks remain in this fabrication process. Two important drawbacks are associated with the isotropic etching of the oxide 3 underneath the silicon island 2 to form the cavity 4. First of all, due to the absence of control of the cavity etch, large parasitic capacitances are formed once the polysilicon 7 is deposited in the cavity. The reason for this is that the cavity 4 etched in the oxide 3 is larger than the windows in the resist. Secondly, it is impossible to fabricate devices with a large width since this would also increase the length of the cavity. This would lead to either a large gate length, or large overlap capacitances.

The cavity can be anisotropically etched in the oxide before fabricating the silicon island, as described in US-5583362. This enables a very precise control of the size of the cavity, and thus of the size of the gate. Once the cavity is formed, according to US-5583362, it is filled with silicon nitride and the silicon island is made by LPVCD deposition of polysilicon and etching. The silicon nitride film is then removed, and the polysilicon gate is formed in a manner similar to what is described in Colinge et *al.*

US-5583362 also proposes a process to make a bridge-like channel without etching a cavity in the oxide. A silicon nitride island is made above a wafer covered with oxide. Channel polysilicon is deposited across this silicon nitride island. The silicon nitride is then removed, and a bridge of channel polysilicon remains. After gate oxidation, gate polysilicon is deposited by LPCVD.

Trouble can occur in this case when removing the silicon nitride: the silicon bridge can droop. Different techniques to support the silicon bridge are proposed, but this complicates the fabrication process. Moreover, polysilicon is not very suited to form the channel: carrier mobility is reduced because of the grains in the polysilicon, which results in the device having less current drive and slowing down.

According to US-5580802, a fabrication method starts with an SOI wafer. SOI wafers have the property of having a thin silicon film over a buried oxide. The SOI wafer is covered with gate dielectric and gate material, e.g. polysilicon. The gate material is etched to form the pattern of the bottom gate. It is covered with insulator, which is planarized. A bulk wafer is oxidized and bonded to the planarized surface of the SOI wafer. The SOI substrate and the buried oxide from the SOI wafer are removed. The buried oxide acts as an etch stop during the removal of the SOI substrate. The top gate dielectric is formed and the top gate material is deposited. The fabricated transistor has two separate gates that have to be connected in order to form a GAA MOSFET. In this realization, a high-temperature oxidation is performed twice, once to form the bottom gate dielectric and once to form the top gate dielectric, which increases the risk for stresses on the bottom gate dielectric (as a dielectric layer of about 3 nm thick is heated up to 1000°C for making the top gate dielectric) and thus for defects to appear in the structure.

It is seen that there are four critical points when fabricating double-gate or gate-all-around transistors:
- Having a single-crystal channel region in order to have a high mobility
- Reducing the parasitic gate-to-source/drain overlap capacitances
- Easy manufacturing process, compatible with the standard CMOS process
- Having only one high temperature oxidation step to form the gate dielectric

Each of the fabrication methods known in the prior art provide a partial answer to some of these concerns, but none of them can fully endorse the above mentioned goals.

"Silicon on nothing" (more generally semiconductor on nothing) transistors are known from Jurczak M. et al. "SON (silicon on nothing) a new device architecture for the ULSI era", VLSI Symposium, 1999. In these devices a semiconductor silicon layer is grown by epitaxy above a SiGe (Silicon-Germanium) layer grown on a bulk silicon substrate. After conventional CMOS process steps carried out until formation of nitride spacers, trenches in source/drain regions are etched to open access to SiGe which is then selectively etched, leaving the silicon layer attached to the gate and isolated from the substrate by an air tunnel. Next, trenches in source/drain regions are filled up with selectively grown silicon and the front-end process is completed. This process thus includes many steps unconventional to typical CMOS and raises quality and reliability issues. Size limitations, more specifically limitations with respect to achievable width to length ratios of the cavity formed by etching away SiGe, are yet unclear.

It is therefore an aim of the present invention to provide an improved fabrication process for certain types of semiconductor devices such as Double-gate transistors of the type Gate-All-Around type or "semiconductor on nothing" devices and circuits.

### Summary of the invention

The above objective is accomplished by a method for fabricating semiconductor devices, such as e.g. transistors, diodes, bipolars, MEMS (Micro-Electro-Mechanical Systems) structures such as sensors and actuators, etc. according to the present invention, which method comprises the steps of:
(a) forming a trench, e.g. by etching, ion milling or any suitable process, in at least a first substrate, e.g. a semiconductor layer or a first insulating layer, which may be itself on any suitable substrate such as semiconductor material, glass, sapphire, etc.; that is the trench may be formed in a multilayer structure whereby the layers may be composed of insulators, semiconductors and/or conductors, depending on the application,
(b) transferring semiconductor material over the trench to form a semiconductor bridge across the trench, the semiconductor bridge defining an active area,
(c) forming a gate insulator on the semiconductor bridge,
(d) applying gate material on the gate insulator, thus forming a gate.

The transferring step (b) may include bonding a semiconductor substrate over the whole or part of the trench. Before the transfer of the semiconductor material the trench may be filled with a material which can be easily removed, e.g. a wax, a resist or other sacrificial material which can be easily etched.

One advantage of working like this, with a trench formed first, and a semiconductor bridge formed afterwards over the trench, is that the dimensions of the trench are easily controllable and precisely defined, for example by an anisotropic etch, such that the width over length ratio thereof can be different from 1, that is, the dimensions of the trench are not limited by an isotropic etching process. Furthermore, overlap capacitances between the active area and the gate material are limited to a value determined by the accuracy of the alignment of the masks in the process.

The trench has specific dimensions which are related to the desired size of the semiconductor device fabricated. In an electronic circuit, the sizes of semiconductor devices can be very different, so each device has its own dimensions and also each trench must have its own dimensions.

Along with the trench, alignment marks for subsequent process steps are preferably realized.

The semiconductor bridge over the trench may enclose the trench (cover the trench completely), thus forming a cavity under the semiconductor bridge, or it may leave spaces at its sides. If spaces are left at the sides of the bridge, a gate insulator may be formed all around the semiconductor bridge e.g. by growing SiO₂, and gate material may surround the combination of semiconductor bridge and gate insulator. This may be the basis for a double gate transistor of the type Gate-All-Around. By adequately patterning the gate insulator and the gate material on top and/or on the sides of the semiconductor bridge, devices with only a bottom gate, only side gates or with bottom and side gates can be formed. If the semiconductor bridge totally encloses the trench, gate insulator may only be formed on top of the semiconductor bridge, and gate material may only be applied on top of the gate insulator. This may be the basis for a "semiconductor on nothing" transistor.

A method according to the present invention may furthermore comprise a step of patterning the gate as desired by the application. This may include patterning the gate to form several separate gates over the same cavity.

A method according to the present invention may furthermore comprise the step of forming contact regions in the semiconductor bridge. For example, in the case of MOSFETs, this means forming source and drain regions in the semiconductor bridge; in case of diodes, this means forming anode and cathode regions in the semiconductor bridge; in case of bipolar transistors, this means forming emitter and collector regions in the semiconductor bridge. This step of forming contact regions may be a conventional CMOS step, which is carried out according to the kind of CMOS technology used. Furthermore, a conductive layer may be formed to contact said contact regions and said gate (e.g. a metallization or polysilicon step).

The trench and/or the semiconductor bridge may be structured to be used in MEMS applications, e.g. waveguides at millimetre and optical wavelengths, fluidic channels, moving beams, resonators, etc.

A method according to the present invention presents a series of advantages. First of all, fabricating a semiconductor device of the Double-Gate Gate-All-Around type according to the present invention minimizes the drawbacks of previous propositions: unconventional process steps compared to a conventional CMOS process, unreliable quality of semiconductor material, and large parasitic capacitances. Furthermore, the proposed method uses known techniques. Only one additional mask step is needed compared to a conventional single-gate CMOS process.

Although there has been constant improvement, change and evolution in methods to obtain semiconductor devices, the present concepts are believed to represent substantial new and novel improvements, including departures from prior practices, resulting in the provision of more efficient and reliable devices of this nature.

Other features and advantages of the present invention will become apparent from the following detailed description, taken in conjunction with the accompanying drawings, which illustrate, by way of example, the principles of the invention.

### Brief description of the drawings

Fig. 1 is a perspective view of a prior art Silicon island etched in a thin Silicon film on top of a dielectric.
Fig. 2 is a perspective view of a cavity being etched underneath a Silicon island, according to the prior art.
Fig. 3a is a longitudinal and Fig. 3b a transversal vertical cross-section of a double gate device of the Gate-All-Around type as known in the prior art.

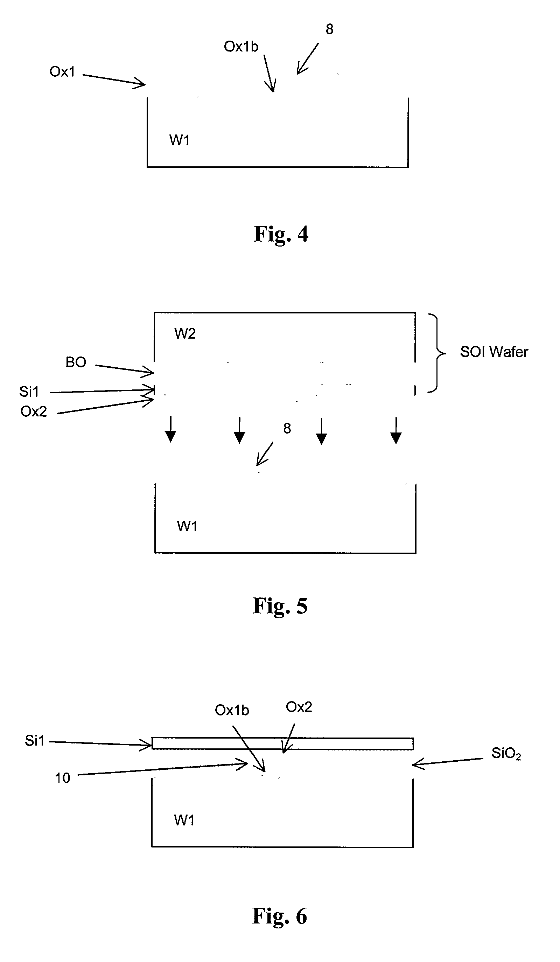

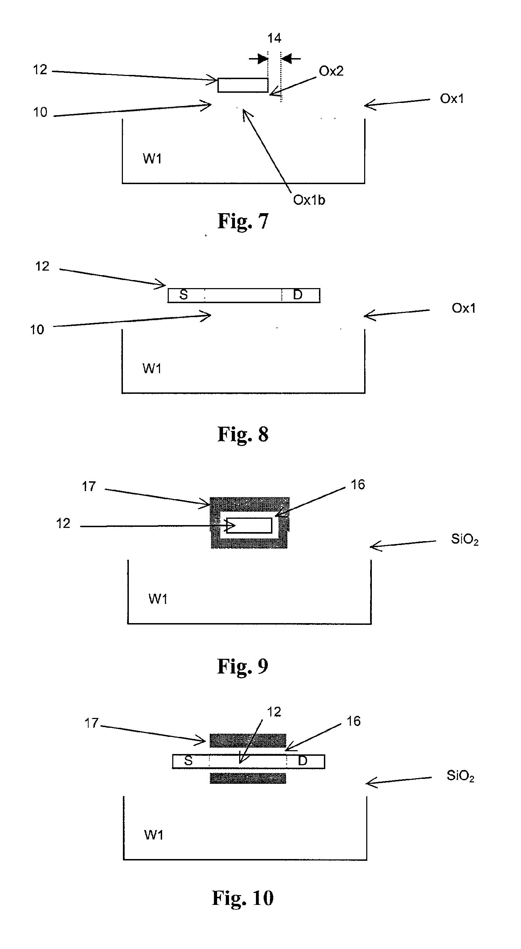

Fig. 4 to 10 illustrate different steps of a method for forming a GAA device according to a first embodiment of the present invention. In Fig. 4 a trench is formed in an insulating layer. In Fig. 5, an SOI wafer is flipped and bonded onto the insulating layer of Fig. 4. In Fig. 6, substrate and buried oxide of the SOI wafer are removed. In Fig. 7 and 8, the active semiconductor area is defined, Fig. 7 being a transversal view and Fig. 8 being a longitudinal view. In Fig. 9 and 10, gate oxide is grown and polysilicon is deposited around the active area, Fig. 9 being a transversal view and Fig. 10 being a longitudinal view.
Fig. 11 and 12 illustrate some steps of a method for forming a GAA device according to a second embodiment of the present invention. In Fig. 11 a supporting wafer with a thin semiconductor layer lying over a cleaving layer is flipped and bonded on an insulating layer provided with a trench. Fig. 12 illustrates the supporting wafer after cleaving, splitting, delaminating or etching the thin semiconductor layer from the supporting wafer along the cleaving layer.
Fig. 13 to 15 illustrate different steps of part of a further method for forming a GAA device according to a further embodiment of the present invention. In Fig. 13 a trench is formed in a semiconductor layer. In Fig. 14, an SOI wafer is flipped and bonded onto the semiconductor layer of Fig. 13. In Fig. 15, substrate and buried oxide of the SOI wafer are removed.

In the different drawings, the same reference figures refer to the same or analogous elements.

### Description of the illustrative embodiments

The present invention will be described with respect to particular embodiments and with reference to certain drawings but the invention is not limited thereto but only by the claims. The drawings described are only schematic and are non-limiting.

Fig. 4 to 10 describe a fabrication method according to a first embodiment of the present invention.

As shown in Fig. 4, an oxide layer, e.g. silicon dioxide layer Ox1, is grown or deposited on a bulk silicon substrate, W1. Typically, the oxide layer Ox1 can be 400 nm to 1000 nm thick. The surface of the oxide layer Ox1 is coated with photoresist, and through a photolithograpic step, windows are opened in the resist. The mask used for this step, called mask A, is the intersection between the mask for the active area and the mask for the gate pattern, but with adapted dimensions. The length is just slightly adapted by a space that is compatible with the further alignment of the gate pattern over the cavity. This depends on the alignment precision available in the full (e.g. CMOS) process. The width may be increased by the space necessary to connect the bottom and the top gate; this depends on the desired thickness of the polysilicon gate. It is to be observed that this mask must also include an alignment pattern for the definition of the active area and for the gate pattern.

The oxide is anisotropically etched, for instance with a plasma RIE (Reactive Ion Etching). A trench 8 is formed, as deep as needed by the polysilicon gate.

It is to be noted that it is better to leave some oxide, Ox1b as shown in Fig. 4, between the trench 8 and the silicon W1. The larger the thickness of this oxide Ox1b, the more the parasitic capacitance between the polysilicon gate and the substrate W1 in the final device will be reduced. This oxide Ox1 b also has an advantage during later stages in the fabrication process.

Thereafter, an SOI (Silicon-On-Insulator) wafer (W2, BO, Si1) is used as supporting wafer, as shown in Fig. 5. This SOI wafer comprises a silicon substrate W2, a buried oxide BO, and a thin silicon film Si1, which is typically 40 nm to 100 nm. The thickness of the silicon film Si1 depends on the desired thickness of the channel region of the GAA transistor. An ultra-thin oxide Ox2 can be grown on this thin silicon film Si1. The growing of this ultra-thin oxide Ox2 is however not necessary, the native oxide may be sufficient in order to make a strong bonding. The wafer W1 with the trench 8 in the oxide Ox1 is bonded to the oxide Ox2 grown on the SOI wafer. That way, the trench 8 forms a cavity 10. Suitable bonding methods are described in e.g. Q.-Y. Tong and U. Gösele, Semiconductor wafer bonding: science and technology, J. Wiley and Sons, 1998.

In a further step, the substrate W2 of the SOI wafer is removed (for instance by etching with TMAH or Tetramethylammonium hydroxide). The buried oxide BO acts as an etch-stop. The buried oxide BO is removed thereafter (for instance by etching with HF or Hydrofluoric Acid), leaving the thin silicon film Si1 at the surface, as shown in Fig. 6.

A photolithographic step then defines the active area in the thin silicon film Si1 over the cavity 10. The mask used for this step must be aligned on the alignment patterns defined by mask A. An active area 12 is then obtained by MESA etching. The result is a bridge formed of silicon and a thin layer of oxide Ox2 over the trench 8 in oxide Ox1. Fig. 7 is a width view (transversal view) of the structure, and Fig. 8 is a length view (longitudinal view) thereof. It is to be noted that, in Fig. 7, a space 14 is left between an edge of the active area 12 and an edge of the cavity 10, in order to later on enable contacting of the top and bottom parts of the gate.

Two problems can occur when etching the island in the silicon film Si1:
1) When Ox1 b and Ox2 are not present in the structure, there is no etch-stop and the etching will continue in the silicon underneath the cavity .
2) When Ox2 is present, it must be removed with an isotropic etch (for instance with HF). But this increases the dimensions of the cavity.

It seems thus desirable to use Ox1 b, but to avoid Ox2.

The oxide Ox2 is removed. A possible solution to avoid the over-etch of the cavity 10 when removing the oxide Ox2, is to protect the walls of the cavity 10 with an etch-stop barrier, for instance by depositing a thin layer of silicon nitride or polysilicon into the trench 8 prior to the bonding (not shown on the drawings). This layer will prevent the over-etch of the cavity 10 when removing Ox2 after the bonding. Such an etch-stop barrier might also be realized prior to trench formation, e.g. by multi-layering Ox1b. Another way to apply the etch-stop barrier after trench formation is e.g. by molecular assembly.

A gate oxide 16 is then grown all around the active area 12 forming the silicon bridge. The high temperature during oxidation will make the bonding stronger. An implantation is made to adjust the threshold voltage of the gate. Gate polysilicon 17 is deposited e.g. by LPCVD, fills the cavity 10 and completely surrounds the silicon bridge together with the gate oxide 16. The gate is patterned with a photolithographic step and etching. It is to be noted that the mask must be aligned on the alignment patterns of mask A.

The remaining of the process follows classical CMOS process steps: doping of the gate polysilicon, implantation of source S and drain D regions, isolation oxide deposition, contact holes and metallization.

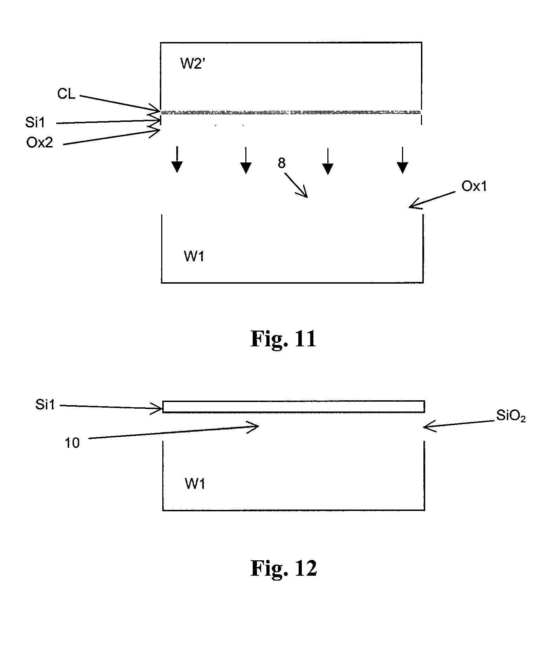

Fig. 11 and 12 describe some steps of a fabrication method according to a second embodiment of the present invention.

This second embodiment also starts from Fig. 4. The initial process steps where the trench is formed in an oxide layer Ox1 grown or deposited on a bulk silicon substrate W1 are identical as for the first embodiment.

An ultra-thin oxide Ox2 can be grown on a silicon wafer W2' with a cleaving layer CL, which is formed e.g. by implantation of hydrogen. This silicon wafer W2' with cleaving layer CL is used as supporting wafer. This may be considered as or equivalent to an SOI wafer with the insulating layer replaced by a cleaving layer. The cleaving layer CL could typically be located at a depth of 40 nm to 100 nm, depending on the desired thickness of the silicon film (Si1) for the GAA transistor. The wafer W1 with the trench 8 in the oxide Ox1 is bonded to the oxide Ox2 of the second wafer W2', as represented in Fig. 11.

The second wafer W2' is then cleaved, slit, delaminated or etched along the cleaving layer CL, e.g. following the SMART-CUT process, as described in Bruel M., Silicon-on-Insulator Material Technology, in Electronics Letters, vol.32, n°14, pp.1201-1202 (1995), following the ELTRAN process, as described in Yonehara T. et al., Epitaxial layer transfer by bond and etch back of porous Si, in Applied Physics Letters, vol.64, n°16, pp.2107-2110 (1994), or following an other similar process. That way, the silicon wafer W2' is removed. The thin silicon film Si1 is at the surface, as shown in Fig. 12, and will be the channel region of the double gate (DG) -GAA transistor. The remaining of the method of the second embodiment is similar to the method according to the first embodiment described above.

Alternatively, as supporting wafer, a wafer could be used with no insulating layer or cleaving layer at all, more specifically if the substrate itself could be removed selectively from the semiconductor layer.

In fact as supporting wafer can be used, according to the present invention, any combination of a substrate and a semiconductor layer, with possibly a specific layer in between them, the aim of which is to allow subsequent removal, cleaving, splitting, delamination, etc. of the substrate from the semiconductor layer.

With a method according to the present invention, T-shaped back gates can for example be provided by adequately structuring (and possibly partly filling) the cavity 10. These T-shaped back gates present a reduced resistance with regard to normal gates. This is important where gates with a short length are desired.

An advantage of the methods described is that they are fully compatible with a standard CMOS process and include only one additional mask step. Bonding techniques are also now well-known by the industry.

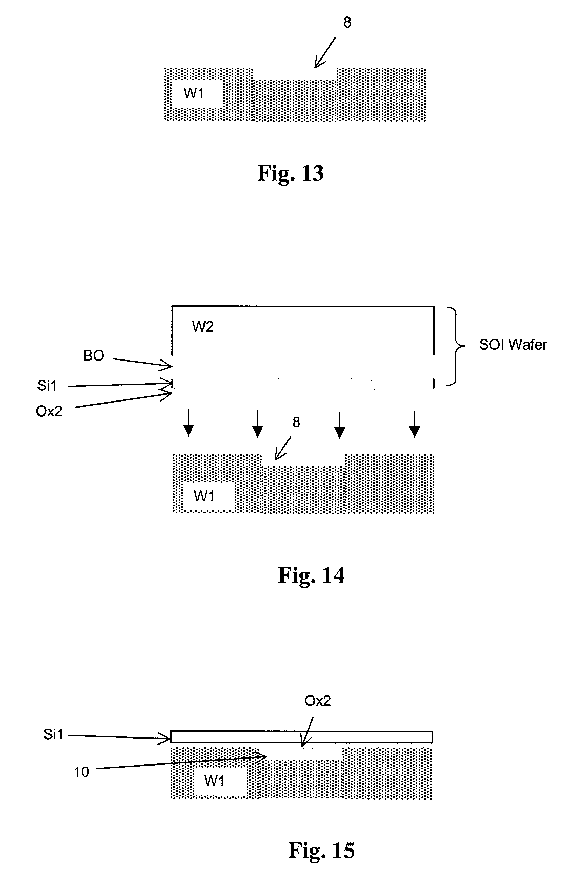

It is to be understood that although specific method steps, as well as materials, have been disclosed herein for carrying out a method according to the present invention, deviations can be made therein without departing from the spirit and scope of the present invention. For example, a further embodiment is described with reference to Figs. 13 to 15.

Fig. 13 shows a bulk silicon substrate, W1, provided with a trench 8, as deep as needed by the polysilicon gate instead of an insulating layer provided with a trench. A semiconductor layer on a further substrate can also be used.

Thereafter, an SOI (Silicon-On-Insulator) wafer (W2, BO, Si1) is used as supporting wafer, as shown in Fig. 14. This SOI wafer comprises a silicon substrate W2, a buried oxide BO, and a thin silicon film Si1, which is typically 40 nm to 100 nm. The thickness of the silicon film Si1 depends on the desired thickness of the channel region of the GAA transistor. A thin oxide layer Ox2 can be grown on this thin silicon film Si1. The wafer W1 with the trench 8 is bonded to the oxide Ox2 grown on the SOI wafer forming a cavity 10. Suitable bonding methods are described in e.g. Q.-Y. Tong and U. Gösele, Semiconductor wafer bonding: science and technology, J. Wiley and Sons, 1998.

In a further step, the substrate W2 of the SOI wafer is removed (for instance by etching with TMAH or Tetramethylammonium hydroxide). The buried oxide BO acts as an etch-stop. The buried oxide BO is removed thereafter (for instance by etching with HF or Hydrofluoric Acid), leaving the thin silicon film Si1 at the surface, as shown in Fig. 15. A semiconductor material has now been applied across the trench 8. Further method steps, e.g. of forming the semiconductor bridge, are carried out in a similar manner to that set out above in relation to Figs. 7 to 10.

## Claims

1. A method for fabricating a semiconductor device or circuit, comprising the steps of:
(a) forming a trench (8) in at least a first substrate,
(b) transferring semiconductor material over the trench to form a semiconductor bridge across the trench (8), the semiconductor bridge defining an active area (12),
(c) forming a gate insulator (16) on the semiconductor bridge,
(d) applying gate material (17) on the gate insulator (16), thus forming a gate.

2. A method according to claim 1, wherein the trench is formed in a semiconductor layer or in a first insulating layer.

3. A method according to claim 1 or 2, wherein transferring the semiconductor material is done by bonding it over the trench.

4. A method according to any of the previous claims, wherein the semiconductor material is transferred to cover the whole of the trench.

5. A method according to claim 4, wherein the semiconductor bridge is formed to cover the whole of the trench.

6. A method according to any of the claims 1 to 4, wherein the semiconductor bridge is formed to cover a part of the trench.

7. A method according to claim 6, wherein the gate insulator is formed around the semiconductor bridge.

8. A method according to claim 7, wherein the gate material surrounds the semiconductor bridge with the gate insulator.

9. A method according to any of claims 1 to 6, wherein the gate insulator is formed on top, bottom and/or sides of the semiconductor bridge.

10. A method according to claim 9, wherein the gate material is formed on top, bottom and/or sides of the semiconductor bridge, over the gate insulator.

11. A method according to any of the preceding claims, furthermore comprising the step of:
(e) patterning the gate.

12. A method according to any of the preceding claims, furthermore comprising the step of:
(f) forming contact regions in the semiconductor bridge.

13. A method according to claim 12, furthermore comprising the step of:
(g) forming a conductor layer to said contact regions and to said gate.

14. A method according to any previous claim, wherein the first substrate comprises a first insulating layer and wherein a supporting wafer comprising a second substrate, a second insulating layer, a second semiconductor layer and a third insulating layer, is bonded with its third insulating layer on the first insulating layer provided with the trench.

15. A method according to claims 14 or 15, wherein the third insulating layer is omitted, and the supporting wafer is bonded with the second semiconductor layer on the first insulating layer provided with the trench.

16. A method according to any of the claims 1 to 13, wherein the first substrate comprises a first semiconductor layer and wherein a supporting wafer comprising a second substrate, a second insulating layer, a second semiconductor layer and a third insulating layer, is bonded with its third insulating layer on the first semiconductor layer provided with the trench.

17. A method according to claim 14 or 16, wherein the supporting wafer comprises a second substrate, a cleaving layer, a second semiconductor layer and a third insulating layer or comprises a second substrate and a second semiconductor layer and a third insulating layer with no second insulating layer or cleaving layer.

18. A method according to any of claims 14 to 17, wherein the second substrate and the second insulating layer are removed after bonding.

19. A method according to claim 18, wherein the second semiconductor layer of the supporting wafer is patterned to form the semiconductor bridge.

20. A method according to any of the previous claims, wherein a layer of etch-stop barrier is incorporated into the trench preferably prior to forming the semiconductor bridge.

21. A method according to any of the previous claims, wherein the trench has dimensions related to the desired size of the semiconductor device fabricated.

22. A method according to any of the previous claims, wherein alignment marks for subsequent process steps are realised along with the trench.

23. A method according to any of the previous claims, wherein the trench is structured so that the bottom gate will have a desired shape.
